# EUROPEAN PATENT APPLICATION

(11) **EP 4 718 024 A1**
(43) Date of publication of application: **01.04.2026**
(21) Application number: 25202990.5
(22) Date of filing: 18.09.2025
(51) Int. Cl.: G01B 15/02, G01G 17/02, G01N 23/16, G21K 1/093

(54) **THICKNESS MEASUREMENT DEVICE**

(30) Priority: 26.09.2024 JP 2024167586
(71) Applicant: Yokogawa Electric Corporation, Tokyo 180-8750 (JP)
(72) Inventor: TAGUCHI, Tomoya, Musashino-shi, Tokyo, 180-8750, (JP); SAKAI, Rena, Musashino-shi, Tokyo, 180-8750, (JP); HORIKOSHI, Kumiko, Musashino-shi, Tokyo, 180-8750, (JP); NINAGAWA, Yuuto, Musashino-shi, Tokyo, 180-8750, (JP)
(74) Representative: Winter, Brandl - Partnerschaft mbB

(57) **Abstract**

A measurement device includes a radiation unit 20 that houses inside a charged particle radiation source 21; a detection unit 30 that houses inside a detection device 31 that detects charged particle radiation radiated from the charged particle radiation source and that is arranged with a clearance between the detection unit 30 and the radiation unit 20; and a magnetic field generator 40 that generates a magnetic field from a side of one of the radiation unit 20 and the detection unit 30 toward a side of the other between the radiation unit 20 and the detection unit 30 and, in the radiation unit 20, an output port 23a that allows the charged particle radiation radiated from the charged particle radiation source 21 to be output to outside is formed in a position opposed to the detection unit 30, and, in the detection unit 30, an incidence port 33a that allows the charged particle radiation to be incident on the inside is formed in a position opposed to the output port 23a.

## Description

### CROSS-REFERENCE TO RELATED APPLICATION

The present application claims priority to and incorporates by reference the entire contents of Japanese Patent Application No. 2024-167586 filed in Japan on September 26, 2024.

### BACKGROUND OF THE INVENTION

### 1. Field of the Invention

The present disclosure relates to a measurement device.

### 2. Description of the Related Art

A measurement device that measures a thickness of a sheet-like measurement object using charged particle radiation radiated from a charged particle radiation source is known (for example, refer to JP-A-H5-149775). The measurement device includes a radiation unit that houses inside the charged particle radiation source and a detection unit that houses inside a detection device that detects charged particle radiation. In the radiation unit, an output port that allows the charged particle radiation radiated from the charged particle radiation source to be output to the outside is formed. In the detection unit, an incidence port that allows the charged particle radiation output from the radiation unit to be incident on the inside is formed. The radiation unit and the detection unit has a space in between and are arranged with the output port and the incidence port being opposed to each other. A thickness of the measurement object is measured based on a change in a dose of the charged particle radiation that is detected by the detection unit when the measurement object is caused to pass between the radiation unit and the detection unit.

The charged particle radiation that is output from the output port travels toward the incidence port while spreading radially. Accordingly, the charged particle radiation that is output from the output port is not partly incident on the incidence port. The detection unit detects a dose of the charged particle radiation that is incident from the incidence port.

When the charged particle radiation that is incident from the incidence port is too little, the change in the detected dose decreases and accuracy of measurement of the thickness of the measurement object is insufficient in some cases. Increase the dose of charged particle radiation from the charged particle radiation source is considered in order to cause sufficient charged particle radiation to be incident from the incidence port.

An increase in the dose of charged particle radiation from the charged particle radiation source however increases the size of the device to ensure a controlled area widely and leads to necessity of a large setting space.

An object of the present disclosure is to obtain a measurement device that enables an increase in accuracy of measurement while reducing a dose of charged particle radiation from a charged particle radiation source.

### SUMMARY OF THE INVENTION

According to an aspect of an embodiment, a measurement device includes a radiation unit that houses inside a charged particle radiation source; a detection unit that houses inside a detection device that detects charged particle radiation radiated from the charged particle radiation source and that is arranged with a clearance between the detection unit and the radiation unit; and a magnetic field generator that generates a magnetic field from a side of one of the radiation unit and the detection unit toward a side of the other between the radiation unit and the detection unit and, in the radiation unit, an output port that allows the charged particle radiation radiated from the charged particle radiation source to be output to outside is formed in a position opposed to the detection unit, and, in the detection unit, an incidence port that allows the charged particle radiation to be incident on the inside is formed in a position opposed to the output port.

### BRIEF DESCRIPTION OF THE DRAWINGS

FIG. 1 is a perspective view illustrating a schematic configuration of a measurement device according to a first embodiment;
FIG. 2 is a cross-sectional view of a radiation unit and a detection unit that are cut along a plane containing a direction in which a measurement object is fed;
FIG. 3 is a cross-sectional view of the radiation unit cut along the **III-III** line illustrated in FIG. 2;
FIG. 4 is a cross-sectional view of the radiation unit cut along the IV-IV line illustrated in FIG. 2;
FIG. 5 is a diagram illustrating a modification of a magnetic field generator; and
FIG. 6 is a diagram illustrating a measurement device that is provided with a shield.

### DETAILED DESCRIPTION OF THE PREFERRED EMBODIMENTS

A measurement device according to an embodiment of the present disclosure will be described in detail below with reference to the accompanying drawings. Note that the present disclosure is not limited by the embodiment described below.

### First Embodiment

### Schematic Configuration of Measurement Device

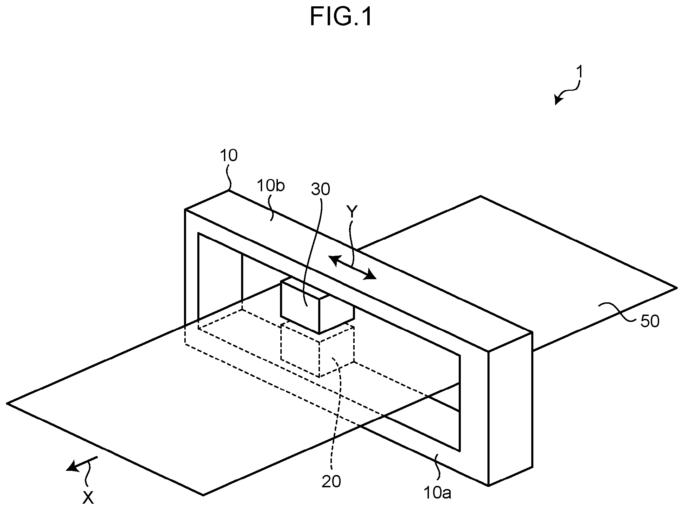

FIG. 1 is a perspective view illustrating a schematic configuration of the measurement device according to a first embodiment. A measurement device 1 is a device that measures a thickness of a measurement object 50 like a sheet. An electrode sheet for a secondary cell, a separator sheet, paper, packaging plastic sheet, a building material sheet, a functional material sheet, an optical film, and a metal foil are exemplified as the measurement object 50. For example, when the measurement object 50 is an electrodes sheet, a slurry is applied thinly and uniformly on a surface of an aluminum foil and is dried at the next step. After the drying, the same application is performed on the back surface of the aluminum foil and drying is performed. By measuring a thickness of the electrode sheet using the measurement device 1, a weight (coating basis weight) to the aluminum foil is measured.

The measurement device 1 includes a frame 10, a radiation unit 20, a detection unit 30, and a magnetic field generator 40. The frame 10 has a lower frame 10a and an upper frame 10b and is a frame member obtained by connecting the lower frame 10a and the upper frame 10b at mutual ends. An area between the lower frame 10a and the upper frame 10b is a measurement space where a thickness of the measurement object 50 is measured.

The radiation unit 20 is supported on the lower frame 10a. The radiation unit 20 is able to run along a longitudinal direction (the direction presented by the arrow Y) of the lower frame 10a. The detection unit 30 is supported on the upper frame 10b. The detection unit 30 is able to run along a longitudinal direction of the upper frame 10b. Note that the radiation unit 20 may be supported on the upper frame 10b and the detection unit 30 may be supported on the lower frame 10a.

The radiation unit 20 and the detection unit 30 are arranged such that the radiation unit 20 and the detection unit 30 are opposed to each other. A gap is provided between the radiation unit 20 and the detection unit 30. The measurement object 50 that moves in the direction presented by the arrow X passes the gap between the radiation unit 20 and the detection unit 30. While the measurement object 50 is passing, the radiation unit 20 and the detection unit 30 are caused to run in a state of being opposed to each other.

### Radiation Unit and Detection Unit

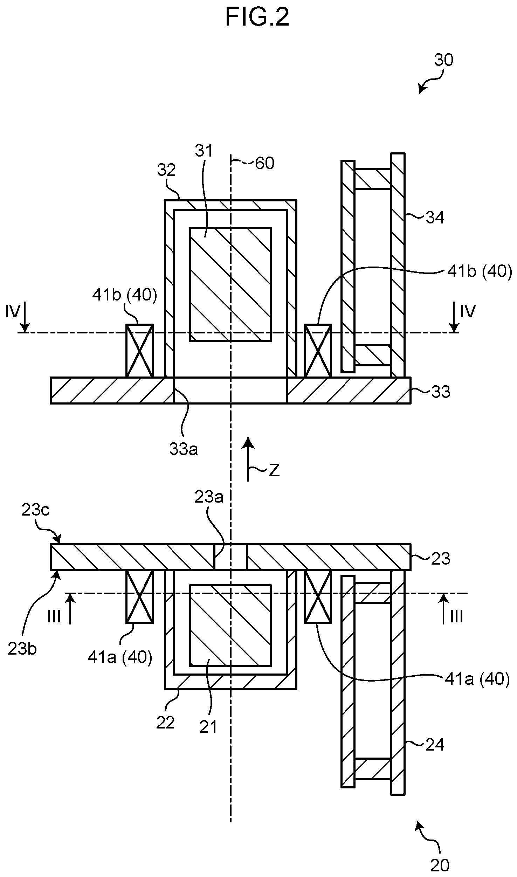

FIG. 2 is a cross-sectional view of the radiation unit and the detection unit that are cut along a plane containing a direction in which the measurement object is fed.

The radiation unit 20 includes a charged particle radiation source 21, a radiation-side housing 22, and a radiation-side base 23.

Charged particle radiation is radiated from the charged particle radiation source 21. Beta-rays, alpha rays, and electron beams, etc., are exemplified as charged particle radiation. **In** the case where charged particle radiation is beta rays, a sealed container in which a nuclide of 85kr that is a radioactive gas is sealed is exemplified as the charged particle radiation source 21.

The radiation-side housing 22 houses the charged particle radiation source 21 inside. One face of the radiation-side housing 22 facing the side of the detection unit 30 is open. The radiation-side base 23 blocks the opening of the detection unit 30. The radiation-side base 23 is formed larger than the opening of the radiation-side housing 22. A first adjacent device 24 is mounted on the radiation-side base 23 in a position adjacent to the radiation-side housing 22.

An output port 23a that is an opening is formed in the radiation-side base 23 in a position where the opening of the radiation-side housing 22 is blocked. The output port 23a allows the inside and the outside of the radiation-side housing 22 to communicate. The charged particle radiation is output to the outside of the radiation-side housing 22 from the output port 23a.

Although illustration in the drawing is omitted, the radiation unit 20 is provided with a shutter mechanism for preventing the charged particle radiation from being output from the output port 23a when a thickness of the measurement object 50 is not measured. The first adjacent device 24 is provides with a power system and a control circuit for driving the shutter mechanism.

The detection unit 30 includes a detection device 31, a detection-side housing 32, and a detection-side base 33.

The detection device 31 is a device that detects a dose of the charged particle radiation. The detection-side housing 32 houses the detection device 31 inside. One face of the detection-side housing 32 facing the side of the radiation unit 20 is open. The detection-side base 33 blocks the opening of the detection-side housing 32. The detection-side base 33 is formed larger than the opening of the detection-side housing 32. A second adjacent device 34 is mounted on the detection-side base 33 in a position adjacent to the detection-side housing 32.

The detection-side base 33 is opposed to the radiation-side base 23 with a gap in between. The gap between the radiation-side base 23 and the detection-side base 33 is the gap between the radiation unit 20 and the detection unit 30.

An incidence port 33a that is an opening is formed in the detection-side base 33 in a position where the opening of the detection-side housing 32 is blocked. The incidence port 33a is formed in a position opposed to the output port 23a of the radiation unit 20. The incidence port 33a allows the inside and the outside of the detection-side housing 32 to communicate.

The charged particle radiation that is output from the output port 23a of the radiation unit 20 is incident on the inside of the detection-side housing 32 via the incidence port 33a. A dose of the charged particle radiation that is incident on the inside of the detection-side housing 32 is detected by the detection device 31.

The second adjacent device 34 is provided with a power system and a control circuit for driving the detection device 31.

### About Magnetic Field Generator

The magnetic field generator 40 generates a magnetic field from a side of one of the radiation unit 20 and the detection unit 30 toward a side of the other between the radiation unit 20 and the detection unit 30. Note that, in FIG. 2, the orientation of the magnetic field in the case where the side of the radiation unit 20 is one side and the side of the detection unit 30 is the other side is presented by the arrow Z.

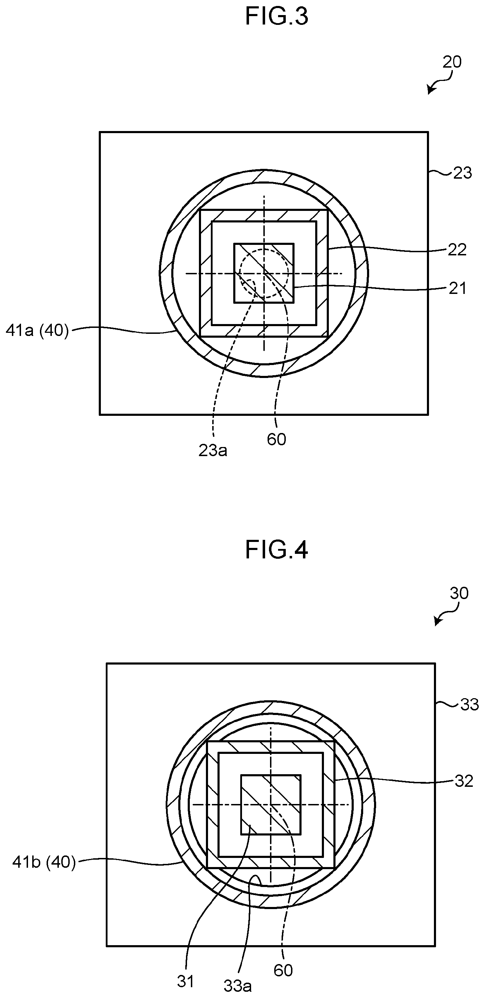

The magnetic field generator 40 is formed by including a first coil 41a and a second coil 41b being included therein. The first coil 41a is provided in the radiation unit 20. FIG. 3 is a cross-sectional view of the radiation unit cut along the III-III line illustrated in FIG. 2. Note that FIG. 3 gives an illustration omitting the first adjacent device 24 for easy understanding.

The first coil 41a is, when viewed along an axis 60 passing the output port 23a and the incidence port 33a, a coil surrounding the charged particle radiation source 21 about the axis 60. More specifically, the first coil 41a is provided on a face 23b serving as the side on which the radiation-side housing 22 is provided in the radiation-side base 23. The first coil 41a is provided such that, when viewed along the axis 60, the first coil 41a surrounds the radiation-side housing 22. Note that the first coil 41a may be provided on a face 23c opposed to the detection-side base 33 in the radiation-side base 23. The axis 60 preferably passes the center of the output port 23a and the center of the incidence port 33a. Note that the first coil 41a passes between the radiation-side housing 22 and the first adjacent device 24. Accordingly, in other words, the first adjacent device 24 is arranged adjacently to the first coil 41a.

The second coil 41b is provided in the detection unit 30. FIG. 4 is a cross-sectional view of the radiation unit cut along the IV-IV line illustrated in FIG. 2. Note that FIG. 4 gives an illustration omitting the second adjacent device 34 for easy understanding.

The second coil 41b is, when viewed along the axis 60, a coil surrounding the detection device 31 about the axis 60. More specifically, the second coil 41b is provided on a face 33b serving as the side on which the detection-side housing 32 is provided in the detection-side base 33. The second coil 41b is provided such that, when viewed along the axis 60, the second coil 41b surrounds the detection-side housing 32. Note that the second coil 41b passes between the detection-side housing 32 and the second adjacent device 34. Accordingly, in other words, the second adjacent device 34 is arranged adjacently to the second coil 41b. The second coil 41b may be provided on a face 33c opposed to the radiation-side base 23 in the detection-side base 33.

Flowing a current through the first coil 41a and the second coil 41b generates a magnetic field between the radiation unit 20 and the detection unit 30 along the direction presented by the arrow Z in FIG. 2. Note that the first coil 41a and the second coil 41b form a so-called Helmholtz coil, which enables formation of a more uniform magnetic field between the radiation unit 20 and the detection unit 30.

### Measurement of Thickness of Measurement Object

Back to FIG. 1, in the measurement device 1, to measure a thickness of the measurement object 50, the measurement object 50 is caused to pass between the radiation unit 20 and the detection unit 30 in the state where the radiation unit 20 and the detection unit 30 are caused to run in a state of being opposed to each other. While the radiation unit 20 and the detection unit 30 are being caused to run, charged particle radiation is output from the output port 23a. The charged particle radiation that is output from the output port 23a is transmitted through the measurement object and reaches the detection device 31 of the detection unit 30. In the measurement device 1, a thickness of the measurement object 50 is calculated based on an amount of attenuation of the dose of the charged particle radiation at the time when the charged particle radiation is transmitted through the measurement object 50.

### About Spread of Charged Particle Radiation

The charged particle radiation that is radiated from the charged particle radiation source 21 and that is output from the output port 23a travels toward the detection unit 30 while spreading radially. For this reason, the charged particle radiation that is output from the output port 23a partly passes a position deviating from the incidence port 33a and cannot reach the detection device 31.

In the measurement device 1, a thickness of the measurement object 50 is calculated based on the amount of attenuation of the dose of the charged particle radiation that is transmitted through the measurement object 50. A larger amount of dose of the charged particle radiation that reaches the detection device 31 is preferable to measure a thickness of the measurement object 50 accurately. It is thus desirable that the charged particle radiation that is output from the output port 23a be caused to be incident on the incidence port 33a as much as possible.

In the measurement device 1, as illustrated in FIG. 2, a magnetic field from the radiation unit 20 toward the detection unit 30 is formed by the magnetic field generator 40 between the radiation unit 20 and the detection unit 30. When a component that is not parallel to the magnetic field is contained in the direction of motion of electrons for generating charged particle radiation, the electrons are subject to the Lorentz force. Because of acceleration motion caused by the Lorentz force and motion in the same direction as that of the magnetic field, the electrons have helical motion. In other words, the charged particle radiation that is output from the output port 23a, that spreads radially, and that does not travel toward the incidence port 33a is subject to the Lorentz force and the direction in which the charged particle radiation travels is deflected to a direction toward the incidence port 33a.

Accordingly, even when the dose of the charged particle radiation that is output from the output port 23a is the same, providing the magnetic field generator 40 enables more charged particle radiation to be incident on the incidence port 33a. Incidence of more charged particle radiation on the incidence port 33a increases charged particle radiation that reaches the detection device 31. Accordingly, it is possible to increase accuracy of measuring a thickness of the measurement object 50 without increasing the doze of the charged particle radiation that is output from the output port 23a. In other words, the measurement device 1 makes it possible to increase the accuracy of measurement while reducing the doze of the charged particle radiation from the charged particle radiation source 21. When the first coil 41a and the second coil 41b form a Helmholtz coil, a uniform magnetic field enables deflection of the direction of travel of more charged particle radiation to a direction toward the incidence port 33a.

Increasing the controlled area is avoided because the doze of the charged particle radiation is reduced and accordingly the size of the measurement device 1 is reduced and the space in which the measurement device 1 is set is reduced.

Radial spread of the charged particle radiation lowers accuracy of detection at an end of the measurement object 50 in some cases; however, deflecting the charged particle radiation makes it possible to inhibit accuracy of detection at the measurement object 50 from lowering.

Note that the magnetic field generator 40 may be formed of only the first coil 41a without the second coil 41b. The orientation of the magnetic field that is generated from the first coil 41a is close to one parallel to the arrow Z illustrated in FIG. 2, and the like, in an area close to the first coil 41a. For this reason, providing the first coil 41a on the side of the detection unit 30 makes it possible to deflect the charged particle radiation to the direction presented by the arrow Z in the vicinity of the detection unit 30 and cause more charged particle radiation to be incident from the incidence port 33a. Thus, when the magnetic field generator 40 is formed of only the first coil 41a, it is preferable that the first coil 41a be provided on the side of the detection unit 30.

### Modification of Magnetic Field Generator

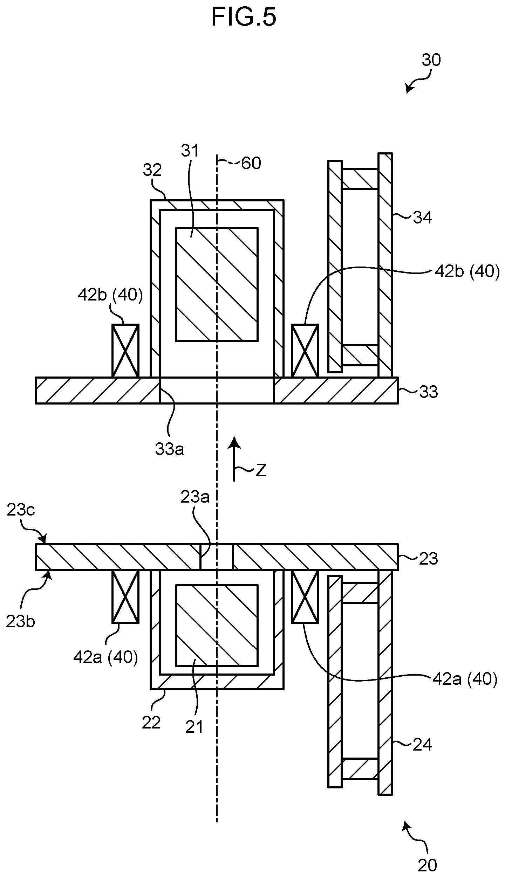

FIG. 5 is a diagram illustrating a modification of a magnetic field generator. Like FIG. 2, FIG. 5 illustrates a cross-sectional view of a radiation unit and a detection unit that are cut along a plane containing a direction in which a measurement object is fed. The magnetic field generator 40 may be formed by including a first magnet 42a and a second magnet 42b.

The first magnet 42a is provided in the radiation unit 20 similarly to the first coil 41a. The shape of the first magnet 42a is formed in an annular shape on the axis 60 also similarly to the first coil 41a. In other words, one obtained by replacing the first coil 41a illustrated in FIG. 2 and FIG. 3 with a permanent magnet formed in an annular shape is the first magnet 42a. Note that the direction of the magnetic pole of the first magnet 42a is parallel to the axis 60.

The second magnet 42b is provided in the detection unit 30 similarly to the second coil 41b. The shape of the second magnet 42b is formed in an annular shape on the axis 60 also similarly to the second coil 41b. In other words, one obtained by replacing the second coil 41b illustrated in FIG. 2 and FIG. 4 with a permanent magnet formed in an annular shape is the second magnet 42b. Note that the direction of the magnetic pole of the second magnet 42b is parallel to the axis 60.

The first magnet 42a may be configured by being divided into multiple parts along the circumferential direction on the axis 60. The direction of the magnetic pole of each of the multiple divided magnets is parallel to the axis 60.

The second magnet 42b may be configured by being divided into multiple parts along the circumferential direction on the axis 60. The direction of the magnetic pole of each of the multiple divided magnets is parallel to the axis 60.

As described above, even when the magnetic field generator 40 is configured by including the first magnet 42a and the second magnet 42b, it is possible to generates a magnetic field from a side of one of the radiation unit 20 and the detection unit 30 toward a side of the other between the radiation unit 20 and the detection unit 30. Accordingly, it is possible to cause the charged particle radiation that is output from the output port 23a, that spreads radially, and that does not travel toward the incidence port 33a to have helical motion using the Lorentz force and deflect the direction in which the charged particle radiation travels to a direction toward the incidence port 33a.

### Additional Example of Shied

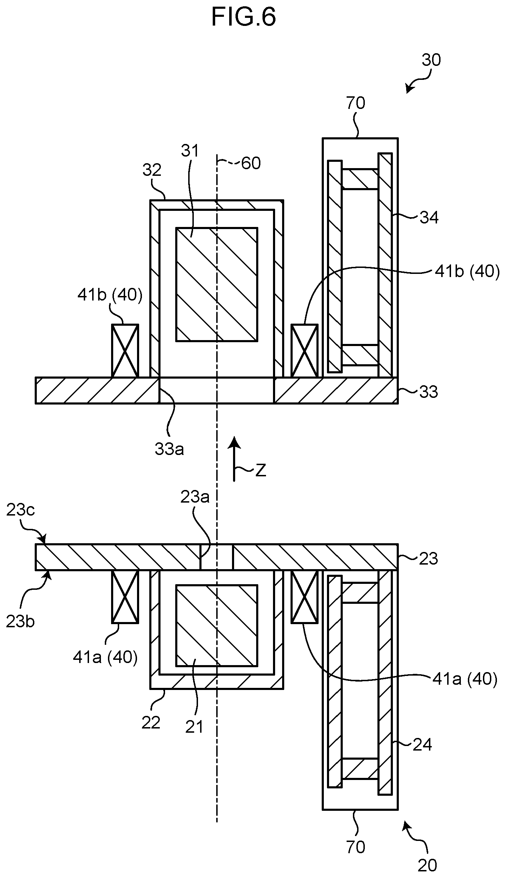

FIG. 6 is a diagram illustrating a measurement device that is provided with a shield. As illustrated in FIG. 6, the measurement device 1 may be provided with a shield 70 that covers the first adjacent device 24 and the second adjacent device 34. Provision of the shield 70 makes it possible to protect the first adjacent device 24 and the second adjacent device 34 from a magnetic field that is generated by the magnetic field generator 40. The shield 70 is made of, for example, a material having high permeability, such as permalloy.

### Others

The following are some examples of a combination of the technical features disclosed herein.
(1) A measurement device comprising: a radiation unit that houses inside a charged particle radiation source; a detection unit that houses inside a detection device that detects charged particle radiation radiated from the charged particle radiation source and that is arranged with a clearance between the detection unit and the radiation unit; and a magnetic field generator that generates a magnetic field from a side of one of the radiation unit and the detection unit toward a side of the other between the radiation unit and the detection unit, wherein, in the radiation unit, an output port that allows the charged particle radiation radiated from the charged particle radiation source to be output to outside is formed in a position opposed to the detection unit, and in the detection unit, an incidence port that allows the charged particle radiation to be incident on inside is formed in a position opposed to the output port.
(2) The measurement device according to (1), wherein the magnetic field generator is provided in one of the radiation unit and the detection unit and is configured to, when viewed along an axis passing the output port and the incidence port, include a first coil surrounding one of the charged particle radiation source and the detection device about the axis.
(3) The measurement device according to (2), wherein the magnetic field generator is provided in the other of the radiation unit and the detection unit and is configured to, when viewed along the axis, include a second coil surrounding the other of the charged particle radiation source and the detection device about the axis.
(4) The measurement device according to (3), wherein the first coil and the second coil form a Helmholtz coil.
(5) The measurement device according to (1), wherein the magnetic field generator is provided in one of the radiation unit and the detection unit and, when viewed along an axis passing the output port and the incidence port, includes a first magnet surrounding one of the charged particle radiation source and the detection device about the axis.
(6) The measurement device according to (5), wherein the magnetic field generator is provided in one of the radiation unit and the detection unit and, when viewed along the axis, includes a second magnet surrounding the other of the charged particle radiation source and the detection device about the axis.
(7) The measurement device according to (6), wherein the first magnet and the second magnet are formed in an annular shape on the axis.
(8) The measurement device according to (6), wherein the first magnet and the second magnet are divided into multiple parts along a circumferential direction.
(9) The measurement device according to (1), further comprising: an adjacent device that is arranged adjacently to the magnetic field generator; and a shield that surrounds the adjacent device and that shields the magnetic field that is generated by the magnetic field generator.
(10) The measurement device according to any of (1) to (9), wherein the charged particle radiation source is a beta ray source that radiates beta rays.
(11) The measurement device according to any of (1) to (10), further comprising a frame that supports the radiation unit and the detection unit such that the radiation unit and the detection unit are able to run with the output port and the incidence port being opposed to each other.

According to the disclosure, there is an effect that it is possible to obtain a measurement device that enables an increase in accuracy of measurement while reducing a dose of charged particle radiation from a charged particle radiation source.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A measurement device comprising:
a radiation unit (20) that houses inside a charged particle radiation source (21);
a detection unit (30) that houses inside a detection device (31) that detects charged particle radiation radiated from the charged particle radiation source and that is arranged with a clearance between the detection unit and the radiation unit; and
a magnetic field generator (40) that generates a magnetic field from a side of one of the radiation unit and the detection unit toward a side of the other between the radiation unit and the detection unit,
wherein, in the radiation unit, an output port (23a) that allows the charged particle radiation radiated from the charged particle radiation source to be output to outside is formed in a position opposed to the detection unit, and
in the detection unit, an incidence port (33a) that allows the charged particle radiation to be incident on inside is formed in a position opposed to the output port.

2. The measurement device according to claim 1, wherein the magnetic field generator is provided in one of the radiation unit and the detection unit and is configured to, when viewed along an axis passing the output port and the incidence port, include a first coil (41a) surrounding one of the charged particle radiation source and the detection device about the axis.

3. The measurement device according to claim 2, wherein the magnetic field generator is provided in the other of the radiation unit and the detection unit and is configured to, when viewed along the axis, include a second coil (41b) surrounding the other of the charged particle radiation source and the detection device about the axis.

4. The measurement device according to claim 3, wherein the first coil and the second coil form a Helmholtz coil.

5. The measurement device according to claim 1, wherein the magnetic field generator is provided in one of the radiation unit and the detection unit and, when viewed along an axis passing the output port and the incidence port, includes a first magnet (42a) surrounding one of the charged particle radiation source and the detection device about the axis.

6. The measurement device according to claim 5, wherein the magnetic field generator is provided in one of the radiation unit and the detection unit and, when viewed along the axis, includes a second magnet (42b) surrounding the other of the charged particle radiation source and the detection device about the axis.

7. The measurement device according to claim 6, wherein the first magnet and the second magnet are formed in an annular shape on the axis.

8. The measurement device according to claim 6, wherein the first magnet and the second magnet are divided into multiple parts along a circumferential direction.

9. The measurement device according to any of claims 1 to 8, further comprising:
an adjacent device (24) that is arranged adjacently to the magnetic field generator; and
a shield (70) that surrounds the adjacent device and that shields the magnetic field that is generated by the magnetic field generator.

10. The measurement device according to any of claims 1 to 9, wherein the charged particle radiation source is a beta ray source that radiates beta rays.

11. The measurement device according to any of claims 1 to 10, further comprising a frame (10) that supports the radiation unit and the detection unit such that the radiation unit and the detection unit are able to run with the output port and the incidence port being opposed to each other.
